(19) **Europäisches Patentamt**
**European Patent Office**
**Office européen des brevets**

(11) **EP 2 397 574 A1**

(12) **EUROPEAN PATENT APPLICATION**
published in accordance with Art. 153(4) EPC

(43) Date of publication:
**21.12.2011 Bulletin 2011/51**

(21) Application number: **10741318.9**

(22) Date of filing: **15.02.2010**

(51) Int Cl.:
*C23C 14/08* (2006.01)    *B32B 9/00* (2006.01)
*C23C 14/56* (2006.01)    *C23C 16/40* (2006.01)
*C23C 16/54* (2006.01)

(86) International application number:
**PCT/JP2010/052219**

(87) International publication number:
**WO 2010/093041 (19.08.2010 Gazette 2010/33)**

(84) Designated Contracting States:
**AT BE BG CH CY CZ DE DK EE ES FI FR GB GR HR HU IE IS IT LI LT LU LV MC MK MT NL NO PL PT RO SE SI SK SM TR**

(30) Priority: **16.02.2009 JP 2009032513**

(71) Applicant: **Mitsubishi Plastics, Inc.**
**Tokyo 103-0021 (JP)**

(72) Inventors:
• **YOSHIDA, Shigenobu**
**Ushiku-shi**
**Ibaraki 300-1201 (JP)**
• **OKAWARA, Chiharu**
**Ushiku-shi**
**Ibaraki 300-1201 (JP)**
• **OZEKI, Kota**
**Ushiku-shi**
**Ibaraki 300-1201 (JP)**

(74) Representative: **Gille Hrabal Struck Neidlein Prop Roos**
**Patentanwälte**
**Brucknerstrasse 20**
**40593 Düsseldorf (DE)**

(54) **PROCESS FOR PRODUCING MULTILAYERED GAS-BARRIER FILM**

(57) Provided are a method for producing a film, which is satisfactory in productivity, exhibits high gas-barrier property immediately after production, and has excellent adhesive strength between constituent layers while maintaining the excellent gas-barrier property, and a gas-barrier film, which is obtained by the method. The method for producing a gas-barrier film includes the steps of: (1) forming an inorganic thin film by a vacuum deposition method on at least one surface of a base film; (2) forming a thin film by a plasma CVD method on the inorganic thin film formed in the step (1); and (3) forming an inorganic thin film by the vacuum deposition method on the thin film formed in the step (2), in which each of the steps (1) and (3), and the step (2) are sequentially carried out at a pressure of $1 \times 10^{-7}$ to 1 Pa, and at a pressure of $1 \times 10^{-3}$ to $1 \times 10^2$ Pa, respectively.

EP 2 397 574 A1

**Description**

Technical Field

The present invention relates to a film excellent in gas-barrier property and a production method for the film.

Background Art

Conventionally, a gas-barrier plastic film including a plastic film as a base and an inorganic thin film formed on a surface thereof is widely used as a wrapping material for articles which require blocking of various gases such as water vapor and oxygen, for example, a wrapping material for preventing deterioration of foods, industrial goods, drugs, and the like. In addition to the wrapping use, in recent years, new use of the gas-barrier plastic film as a transparent conductive sheet used for liquid crystal display devices, solar cells, electromagnetic wave shields, touch panels, EL substrates, color filters, and the like has attracted attention.

With various aims, various improvements have been investigated with respect to the gas-barrier plastic film formed of the inorganic thin film described above. For example, from the viewpoint of transparency or gas-barrier property, there has been disclosed a gas-barrier film including a metal oxide layer, a resin, and a metal oxide layer successively laminated in the stated order on a plastic film and having a total light transmittance of 85% or more (see Patent Document 1). In addition, there has been disclosed a barrier film including a metal oxide layer and an organic layer successively and alternately laminated on a transparent plastic film so as to prevent and suppress damage to a metal oxide (see Patent Document 2).

Meanwhile, Patent Document 3 discloses a barrier film having a gas-barrier film formed of silicon nitride and/or silicon oxynitride on at least one surface of a base and having a structure of a base/a resin layer/a barrier layer/a resin layer/a barrier layer or the like.

Moreover, Patent Document 4 shows that an effect of a film containing a metal oxide having a high carbon content as a stress relaxation layer can prevent cracks in the entire film or peeling-off of the layers, and Patent Document 5 shows a gas-barrier film including a base film/an inorganic thin film/an anchor coat layer/an inorganic thin film.

Patent Document 6 discloses an improvement of barrier property by a laminated deposition film layer obtained by laminating two or more deposition films of silicon oxide on a base by repeating a deposition step twice or more, and Patent Document 7 discloses an improvement of wet heat resistance and gas-barrier property by a gas-barrier laminate having an inorganic oxide layer and a silicon oxynitride carbide layer or a silicon oxycarbide layer arranged in the stated order on a base film.

Moreover, Patent Document 8 discloses a gas-barrier laminate having a gas-barrier thin film including a metal or a metal compound and formed by a physical deposition method on a base, in which a polyimide film formed by a deposition synthesis method is sandwiched between the base and the gas-barrier thin film, and Patent Document 9 discloses production of a gas-barrier material including an organic-inorganic composite film obtained by providing an inorganic compound film by a vacuum deposition method on a base including a polymer resin and distributing an organic compound by a chemical deposition method in the thickness direction of the inorganic compound film.

However, the above-mentioned films show some improvements in target property of each film, but the films are still not sufficient in gas-barrier property, adhesive strength between structural layers of a laminated film, productivity, and the like. Thus, the improvements in the above-mentioned points have been desired.

Citation List

Patent Document

[Patent Document 1] JP 2003-71968 A
[Patent Document 2] JP 2003-231202 A
[Patent Document 3] JP 2004-114645 A
[Patent Document 4] JP 2003-257619 A
[Patent Document 5] WO 2007/34773 A1
[Patent Document 6] JP 04-89236 A
[Patent Document 7] JP 2006-297730 A
[Patent Document 8] JP 10-6433 A
[Patent Document 9] JP 11-302422 A

Summary of Invention

Problem to be solved by the Invention

It is a problem to be solved by the present invention to provide a method for producing a film, which is satisfactory in productivity, exhibits high gas-barrier property immediately after production, and has excellent adhesive strength between constituent layers while maintaining excellent gas-barrier property, and a gas-barrier film, which is obtained by the method.

Means for solving the Problem

The present invention relates to:

(1) a method for producing a gas-barrier film, including the steps of: (1) forming an inorganic thin film by a vacuum deposition method on at least one surface of a base film; (2) forming a thin film by a plasma CVD method on the inorganic thin film formed in the step (1); and (3) forming an inorganic thin film by the vacuum deposition method on the thin film formed in the step (2), in which each of the steps (1) and (3), and the step (2) are sequentially carried out at a pressure of $1 \times 10^{-7}$ to 1 Pa, and at a pressure of $1 \times 10^{-3}$ to $1 \times 10^2$ Pa, respectively, and preferably, each of the steps (1) and (3), and the step (2) are sequentially carried out at a pressure of $1 \times 10^{-6}$ to $1 \times 10^{-1}$ Pa and at a pressure of $1 \times 10^{-2}$ to 10 Pa, respectively; and
(2) a gas-barrier film, including: a base film; (A) an inorganic thin film formed by a vacuum deposition method on at least one surface of the base film; and (B) at least one constituent unit layer including thin films formed successively by a plasma CVD method and the subsequent vacuum deposition method on the inorganic thin film (A), arranged in the stated order.

Advantageous Effects of the Invention

The present invention provides the method for producing a film, which is satisfactory in productivity, exhibits high gas-barrier property immediately after production, and has excellent adhesive strength between constituent layers of the film while maintaining excellent gas-barrier property, and the gas-barrier film, which is obtained by the method.

Brief Description of the Drawing

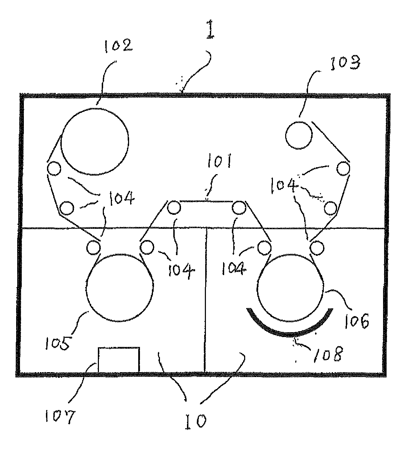

[FIG. 1] A schematic explanatory diagram of a vacuum film formation device for producing a gas-barrier film of the present invention.

Reference Signs List

1       vacuum film formation device
10      film formation chamber
101     polymer base film
102     feeding shaft
103     winding shaft
104     tension roll
105     temperature-controlled film forming drum
106     temperature-controlled film forming drum
107     deposition heating source
108     electrode for plasma CVD

Embodiments for carrying out the Invention

Hereinafter, the present invention is described in detail.

< Method for producing gas-barrier film>

The method for producing a gas-barrier film of the present invention is as mentioned above.

In the present invention, the "gas-barrier film" sometime means "multilayered gas-barrier film".

[Step (1)]

The step (1) is a step of forming an inorganic thin film by a vacuum deposition method on at least one surface of a base film.

Base film

As a base film for the gas-barrier film of the present invention, a thermoplastic polymer film is preferred. Any resin which can be used for usual wrapping materials can be used as a raw material thereof without particular limitation. Specific examples thereof include: polyolefins such as homopolymers or copolymers of ethylene, propylene, and butene; amorphous polyolefins such as cyclic polyolefins; polyesters such as polyethylene terephthalate and polyethylene-2,6-naphthalate; polyamides such as nylon 6, nylon 66, nylon 12, and copolymer nylon; polyvinyl alcohols; ethylene-vinyl acetate copolymer partial hydrolysates (EVOH); polyimides; polyetherimides; polysulfones; polyethersulfones; polyetheretherketones; polycarbonates; polyvinyl butyrals; polyarylates; fluororesins; acrylate resins; and biodegradable resins. Of those, polyesters, polyamides, polyolefins, and biodegradable resins are preferred from the viewpoints of film strength, cost, and the like.
Further, the above-mentioned base film may contain known additives such as an antistatic agent, a light-blocking agent, a UV-absorber, a plasticizer, a lubricant, a filler, a colorant, a stabilizer, a lubricating agent, a cross-linking agent, an anti-blocking agent, and an antioxidant.
The thermoplastic polymer film used as the base film is produced by molding the above-mentioned raw materials. When employed as the base, the film may be unstretched or stretched. Further, the film may be laminated with other plastic bases. The base film can be produced by a conventionally known method. For example, a resin raw material is melted by means of an extruder and extruded through a circular die or a T die, followed by quenching, whereby an unstretched film which is substantially amorphous and non-oriented can be produced. The unstretched film is stretched in a film flow direction (longitudinal direction) or in the film flow direction and an orthogonal direction thereto (transverse direction) by a known method such as monoaxial stretching, tenter-based successive biaxial stretching, tenter-based simultaneous biaxial stretching, or tubular simultaneous biaxial stretching, whereby a film stretched at least in one axial direction can be produced.
The base film has a thickness selected in the range of generally 5 to 500 $\mu$m, preferably 10 to 200 $\mu$m depending on the applications, from the viewpoints of mechanical strength, flexibility, transparency, and the like of the base for the gas-barrier film of the present invention. The base film also includes a sheet-like film having a large thickness. Further, no particular limitation is imposed on the width and length of the film, and these dimensions may be appropriately selected depending on the applications.

Formation of inorganic thin film by vacuum vapor deposition method

Examples of the inorganic substance for forming the inorganic thin film formed by vacuum vapor deposition method on at least one surface of the base film include silicon, aluminum, magnesium, zinc, tin, nickel, titanium, hydrocarbons, oxides thereof, carbides thereof nitrides thereof, and mixtures thereof. Of those, from the viewpoint of gas-barrier property, silicon oxides, aluminum oxides, and hydrocarbons (for example, a substance predominantly formed of a hydrocarbon such as diamond like carbon) are preferred. In particular, silicon oxides or aluminum oxides are preferred in that high gas-barrier property can be consistently maintained. One kind of the above-mentioned inorganic substances may be used alone, or two or more kinds thereof may be used in combination.
In the formation of the above-mentioned inorganic thin film, the vacuum vapor deposition method is employed in that a uniform thin film exhibiting high gas-barrier property can be produced.
The inorganic thin film has a thickness of generally 0.1 to 500 nm, but has a thickness of preferably 0.5 to 100 nm, more preferably 1 to 50 nm from the viewpoints of gas-barrier property and film productivity.
To form a dense thin film, the above-mentioned inorganic thin film is formed under reduced pressure, preferably while the film is conveyed. From the viewpoints of vacuum evacuation performance and barrier property of the resulted inorganic thin film, the pressure in formation of the inorganic thin film is in the range of $1 \times 10^{-7}$ to 1 Pa, preferably $1 \times 10^{-6}$ to $1 \times 10^{-1}$ Pa. When the pressure is in the above-mentioned range, the inorganic thin film has sufficient gas-barrier property and has excellent transparency without causing cracks and peeling-off.

[Step (2)]

The step (2) is a step of forming a thin film by a plasma CVD method on the inorganic thin film formed in the step (1). It is conceived that, through the step (2), defects or the like caused in the inorganic thin film obtained in the step (1) are sealed to improve gas-barrier property and interlayer adhesion property.

Examples of the thin film formed by the plasma CVD method include: a thin film obtained by plasma polymerization of an organic compound to resinify; and a thin film including at least one kind selected from, for example, an inorganic material, an inorganic oxide, and an inorganic nitride, such as a metal, a metal oxide, or a metal nitride, which is obtained by plasma decomposition of an organic compound.

The organic compound used as a raw material component of the plasma polymerization may be a known organic compound, and in terms of a film formation speed, the compound is preferably an organic compound having at least one unsaturated bond or cyclic structure in its molecule, more preferably a monomer, an oligomer, or the like of a (meth) acrylic compound, an epoxy compound, an oxetane compound, or the like, particularly preferably a material including, as a major component, a (meth)acrylic compound containing an acrylic compound, a methacrylic compound, an epoxy compound, and the like.

Any resins can be used as a resin for forming the thin film by plasma CVD method. Specific examples thereof include polyester-based resins, urethane-based resins, acrylic resins, epoxy-based resins, cellulose-based resins, silicon-based resins, vinyl alcohol-based resins, polyvinyl alcohol-based resins, ethylene-vinyl alcohol-based resins, vinyl-based modified resins, isocyanate group-containing resins, carbodiimide-based resins, alkoxyl group-containing resins, oxazoline group-containing resins, modified styrene-based resins, modified silicone-based resins, alkyl titanate-based resins, and poly-p-xylylene resins. One kind of those resins may be used alone, or two or more kinds thereof may be used in combination.

In the present invention, from the viewpoint of gas-barrier property, of the above-mentioned resins, it is preferred to use at least one kind of resin selected from the group consisting of polyester-based resins, urethane-based resins, acrylic resins, epoxy-based resins, cellulose-based resins, silicon-based resins, isocyanate group-containing resins, poly-p-xylylene resins, and copolymers thereof. Of those, acrylic resins are preferred.

As the polyester-based resins, saturated or unsaturated polyesters may be used.

Examples of the dicarboxylic acid component of the saturated polyester include: aromatic dicarboxylic acids such as terephthalic acid, isophthalic aicd, and 2,5-naphthalenedicarboxylic acid; aliphatic dicarboxylic acids such as adipic acid, azelaic acid, and sebacic acid; oxycarboxylic acids such as oxybenzoic acid; and ester forming derivatives thereof. Examples of the glycol component include: aliphatic glycols such as ethylene glycol, 1,4-butanediol, diethylene glycol, and triethylene glycol; alicyclic glycols such as 1,4-cyclohexanedimethanol; aromatic diols such as p-xylenediol; and poly(oxyalkylene) glycols such as polyethylene glycol, polypropylene glycol, and polytetramethylene glycol. The above-mentioned saturated polyester has a linear structure, but may be converted into a branched polyester using a trivalent or more ester-forming component.

On the other hand, examples of the above-mentioned unsaturated polyester include ones shown in the following items (1) and (2).

(1) An unsaturated polyester having a copolymerizable unsaturated group in its resin skeleton and obtained by reacting a raw material component containing a copolymerizable unsaturated group with another raw material component, which is known in each of gazettes such as JP 45-2201 B, JP 46-2050 B, JP 44-7134 B, JP 48-78233 A, and JP 50-58123 A.

(2) An unsaturated polyester obtained by producing a saturated polyester having no copolymerizable unsaturated group and then adding a vinyl-based monomer having a vinyl group and a functional group having reactivity with a functional group such as a hydroxyl group or a carboxylic group present in the saturated polyester to the saturated polyester, which is known in each of gazettes such as JP 49-47916 B and JP 50-6223 B.

Examples of the above-mentioned vinyl-based monomer include: compounds each having an epoxy group and a vinyl group, such as glycidyl methacrylate; compounds each having an alkoxysilanol group and a vinyl group, such as vinylmethoxysilane and methacyloxyethyltrimethoxysilane; compounds each having an acid anhydride group and a vinyl group, such as maleic anhydride and tetrahydrophthalic anhydride; and compounds each having an isocyanate group and a vinyl group, such as a 2-hydroxypropyl methacrylate-hexamethylenediisocyanate adduct.

The urethane-based resin is a resin produced by allowing a polyhydroxy compound and a polyisocyanate compound to react with each other in accordance with a conventional method.

Examples of the polyhydroxy compound in the above-mentioned item (2) include polyethylene glycol, polypropylene glycol, polyethylene/propylene glycol, polytetramethylene glycol, hexamethylene glycol, tetramethylene glycol, 1,5-pentanediol, diethylene glycol, triethylene glycol, polycaprolactone, polyhexamethylene adipate, polyhexamethylene sebacate, polytetramethylene adipate, polytetramethylene sebacate, trimethylolpropane, trimethylolethane, pentaerythritol, and glycerin.

Examples of the above-mentioned polyisocyanate compound include hexamethylene diisocyanate, diphenylmethane diisocyanate, tolylene diisocyanate, isophorone diisocyanate, an adduct of tolylene diisocyanate and trimethylolpropane, and an adduct of hexamethylene diisocyanate and trimethylolethane.

A (meth)acrylic compound useful for forming the acrylic resin is not particularly limited, and specific examples thereof include the following compounds. That is, there are given: monofunctional acrylic acid esters such as 2-ethylhexyl acrylate, 2-hydroxypropyl acrylate, glyceryl acrylate, tetrahydrofurfuryl acrylate, phenoxyethyl acrylate, nonylphenoxyethyl acrylate, tetrahydrofurfuryloxyethyl acrylate, tetrahydrofurfuryloxyhexanolide acrylate, an acrylate of an ε-caprolactone adduct of 1,3-dioxane alcohol, and 1,3-dioxolane acrylate, and methacrylic acid esters obtained by changing "acrylate" in those compounds to "methacrylate;" difunctional acrylic acid esters such as ethylene glycol diacrylate, triethylene glycol diacrylate, pentaerythritol diacrylate, hydroquinone diacrylate, resorcin diacrylate, hexanediol diacrylate, neopentyl glycol diacrylate, tripropylene glycol diacrylate, neopentyl glycol hydroxypivalate diacrylate, neopentyl glycol adipate diacrylate, a diacrylate of an ε-caprolactone adduct of neopentyl glycol hydroxypivalate, 2-(2-hydroxy-1,1-dimethylethyl)-5-hydroxymethyl-5-ethyl-1,3-dioxane diacrylate, tricyclodecanedimethylol acrylate, an ε-caprolactone adduct of tricyclodecanedimethylol acrylate, and 1,6-hexanediol diglycidyl ether diacrylate, and methacrylic acid esters obtained by changing "acrylate" in those compounds to "methacrylate;" and polyfunctional acrylic acid esters such as trimethylolpropane triacrylate, ditrimethylolpropane tetraacrylate, trimethylolethane triacrylate, pentaerythritol triacrylate, pentaerythritol tetraacrylate, dipentaerythritol tetraacrylate, dipentaerythritol pentaacrylate, dipentaerythritol hexaacrylate, an E-caprolactone adduct of dipentaerythritol hexaacrylate, pyrogallol triacrylate, dipentaerythritol propionate triacrylate, dipentaerythritol propionate tetraacrylate, and hydroxypivalylaldehyde-modified dimethylolpropane triacrylate, and methacrylic acid esters obtained by changing "acrylate" in those compounds to "methacrylate." Compounds that may be given as active ray-curable resins as well are also included in the examples.

Examples of the epoxy-based resin include those each obtained by allowing an epoxy resin of bisphenol A type, bisphenol F type, biphenyl type, novolac type, phenol novolac type, glycidyl ester type, or the like, and a curing agent such as a modified aliphatic amine, a modified alicyclic amine, a modified aromatic amine, a ketimine, a polyfunctional phenol, imidazole, mercaptan, an acid anhydride, or dicyandiamide to react with each other.
Specific examples thereof include an epoxy resin derived from m-xylylene diamine and having a glycidyl amine site, an epoxy resin derived from 1,3-bis(aminomethyl)cyclohexane and having a glycidyl amine site, an epoxy resin derived from diaminodiphenylmethane and having a glycidyl amine site, an epoxy resin derived from p-aminophenol and having a glycidyl amine site, an epoxy resin derived from bisphenol A and having a glycidyl ether site, an epoxy resin derived from bisphenol F and having a glycidyl ether site, an epoxy resin derived from phenol novolak and having a glycidyl ether site, and an epoxy resin derived from resorcinol and having a glycidyl ether site. Of those, an epoxy resin derived from m-xylylene diamine and having a glycidyl amine site, and/or an epoxy resin derived from bisphenol F and having a glycidyl ether site, and an epoxy resin derived from 1,3-bis(aminomethyl)cyclohexane and having a glycidyl amine site are preferred in terms of gas-barrier property.

As an epoxy resin-curing agent, there is given a reaction product of the following items (A) and (B) or a reaction product of the following items (A), (B), and (C).

(A) m-Xylene diamine or p-xylene diamine.
(B) A polyfunctional compound which is capable of forming an amide group site by a reaction with a polyamine to form an oligomer and has at least one acyl group.
(C) A monovalent carboxylic acid having 1 to 8 carbon atoms and/or a derivative thereof.

Specific examples thereof include a modification reaction product with m-xylylene diamine or p-xylylene diamine and an epoxy resin or monoglycidyl compound obtained by using m-xylylene diamine or p-xylylene diamine as a raw material, a modification reaction product with an alkylene oxide having 2 to 4 carbon atoms, an addition reaction product with epichlorohydrin, a reaction product with a polyfunctional compound which is capable of forming an amide group site by a reaction with the above-mentioned polyamines to form an oligomer and has at least one acyl group, and a reaction product of a polyfunctional compound which is capable of forming an amide group site by a reaction with the above-mentioned polyamines to form an oligomer and has at least one acyl group and a monovalent carboxylic acid having 1 to 8 carbon atoms and/or a derivative thereof.

Examples of the cellulose-based resin include various cellulose derivative resins such as cellulose, nitrocellulose, acetylcellulose, alkali cellulose, hydroxyethylcellulose, carboxymethylcellulose, sodium carboxymethylcellulose, cellulose acetate butyrate, and cellulose acetate.

Examples of the isocyanate group-containing resin include various diisocyanates such as hexamethylene-1,6-diisocyanate, dicyclohexylmethane-4,4'-diisocyanate, 3-isocyanatomethyl-3,5,5-trimethylcyclohexyl isocyanate, 1,3-bis(isocyanatomethyl)cyclohexane, norbornene diisocyanate, xylene diisocyanate, diphenylmethane-4,4'-diisocyanate, diphenylmethane-2,4'-diisocyanate, 2,4-tolylene diisocyanate, and 2,6-tolylene diisocyanate, various modified products thereof, polyfunctionalized dimers, adducts, allophanates, trimers, carbodiimide adducts, and biurets, and polymerized products and polyhydric alcohol-added polymerized products thereof.
Further, a polyurea-based resin obtained by a reaction and polymerization of the above-mentioned various isocyanates and amines is useful.

Examples of the poly-p-xylylene-based resin include polymers of p-xylylene, a product obtained by substituting benzene ring hydrogen of p-xylylene with chlorine, and a product obtained by substituting methyl group hydrogen of p-xylylene with fluorine.

In addition, even if a diamine compound having a m-xylylene skeleton, a p-xylylene skeleton, or a 1,3-bis(methyl) cyclohexane skeleton such as m-xylylene diamine, p-xylylene diamine, or 1,3-bis(aminomethyl)cyclohexane is used alone, excellent gas-barrier property can be obtained.

As a raw material gas used in formation of the organic thin film by the plasma CVD method, there is given the organic compound used as the raw material component in plasma polymerization, an unsaturated hydrocarbon compound such as acethylene, ethylene, or propylene, a saturated hydrocarbon compound such as methane, ethane, or propane, and an aromatic hydrocarbon compound such as benzene, toluene, or xylene. As the raw material gas, the above-mentioned compounds may be used alone, or two or more kinds thereof may be used in combination. The raw material gas may be diluted with a noble gas such as argon (Ar) or helium (He) before use.

The above-mentioned plasma CVD layer preferably has a silane coupling agent added thereto from the viewpoint of improving interlayer adhesion property. Examples of the silane coupling agent include: epoxy group-containing silane coupling agents such as β-(3,4-epoxycyclohexyl)ethyltrimethoxysilane, γ-glycidoxypropylmethyldiethoxysilane, and γ-glycidoxypropyltrimethoxysilane; amino group-containing silane coupling agents such as γ-aminopropyltrimethoxysilane, N-β(aminoethyl)γ-aminopropylmethyldiethoxysilane, N-β(aminoethyl)γ-aminopropyltrimethoxysilane, and N-β(aminoethyl)γ-aminopropyltriethoxysilane; and mixtures thereof. From the viewpoint of interlayer adhesion property, γ-glycidoxypropyltrimethoxysilane and γ-aminopropyltrimethoxysilane are exemplified for preferred silane coupling agents. One kind of those silane coupling agents may be used alone, or two or more kinds thereof may be used in combination. In view of adhesion property, the silane coupling agent is contained at a ratio of preferably 0.1 to 80 mass%, more preferably 1 to 50 mass% with respect to the resin which forms the plasma CVD thin film.

Further, the above-mentioned plasma CVD thin film preferably includes a curing agent. As the curing agent, polyisocyanates are preferably used. Specific examples of the curing agent include: aliphatic polyisocyanates such as hexamethylene diisocyanate and dicyclohexylmethane diisocyanate; and aromatic polyisocyanates such as xylene diisocyanate, tolylene diisocynate, diphenylmethane diisocynate, polymethylene polyphenylene diisocynate, tolidine diisocyante, and naphthalene diisocynate. In particular, a polyisocyante having two or more functional groups is preferred in view of improving barrier property.

The above-mentioned plasma CVD thin film can include known various additives. Examples of the additive include: polyalcohols such as glycerin, ethylene glycol, polyethylene glycol, and polypropylene glycol; an aqueous epoxy resin; lower alcohols such as methanol, ethanol, n-propanol, and isopropanol; ethers such as ethylene glycol monomethyl ether, propylene glycol monomethyl ether, propylene glycol diethyl ether, diethylene glycol monoethyl ether, and propylene glycol monoethyl ether; esters such as propylene glycol monoacetate and ethylene glycol monoacetate; an antioxidant; a weathering stabilizer; a UV absorber; an antistatic agent; a pigment; a dye; an antibacterial agent; a lubricant; an inorganic filler; an anti-blocking agent; and an adhesive agent.

Further, of the thin films formed by the plasma CVD method, the thin film containing at least one kind selected from, for example, an inorganic material, an inorganic oxide, and an inorganic nitride, such as a metal, a metal oxide, or a metal nitride, is preferably a thin film formed of a metal such as silicon, titanium, DLC, or an alloy of two or more kinds of the metals in terms of the gas-barrier property and adhesion property. Meanwhile, preferred examples of the inorganic oxide or inorganic nitride include oxides and nitrides of the above-mentioned metals and mixtures thereof in terms of gas-barrier property and adhesion property. In the present invention, the plasma CVD thin film is more preferably one which includes at least one kind selected from silicon oxide, silicon nitride, silicon oxynitride, titanium oxide, and diamond like carbon (hereinafter, referred to as "DLC") from the above-mentioned viewpoint. The thin film is preferably obtained by plasma decomposition of an organic compound. Further, the thin film formed by the plasma CVD method characteristically contains carbons originated from the raw materials and through the chemical reaction, and the carbon content is usually 10 atom% or more, which is measured by X-ray photoelectron spectroscopy (XPS).

In particular, as a raw material for formation of the plasma CVD thin film such as a silicon oxide film, a compound such as a silicon compound in any state of a gas, liquid, or solid at normal temperature and pressure may be used. If the compound is in a gas state, the compound can be fed into a discharge space without further treatments, but if the compound is in a liquid or solid state, the compound is gasified before use by means such as heating, bubbling, pressure reduction, or ultrasound irradiation. Further, the compound may be diluted with a solvent or the like before use, and the solvent which may be used is an organic solvent such as methanol, ethanol, or n-hexane or a mixed solvent thereof.

Examples of the above-mentioned silicon compound include silane, tetramethoxysilane, tetraethoxysilane, tetra-n-propoxysilane, tetraisopropoxysilane, tetra-n-butoxysilane, tetra-t-butoxysilane, dimethyldimethoxysilane, dimethyldiethoxysilane, diethyldimethoxysilane, diphenyldimethoxysilane, methyltriethoxysilane, ethyltrimethoxysilane, phenyltriethoxysilane, (3,3,3-trifluoropropyl)trimethoxysilane, hexamethyldisiloxane, bis(dimethylamino)dimethylsilane, bis(dimethylamino)methylvinylsilane, bis(ethylamino)dimethylsilane, N,O-bis(trimethylsilyl)acetamide, bis(trimethylsilyl)carbodiimide, diethylaminotrimethylsilane, dimethylaminodimethylsilane, hexamethyldisilazane, hexamethylcyclotrisilazane, heptamethyldisilazane, nonamethyltrisilazane, octamethylcyclotetrasilazane, tetrakisdimethylaminosilane, tetraisocyanatosilane, tetramethyldisilazane, tris(dimethylamino)silane, triethoxyfluorosilane, allyldimethylsilane, allyltrimethylsilane, benzyltrimethylsilane, bis(trimethylsilyl)acetylene, 1,4-bistrimethylsilyl-1,3-butadiyne, di-t-butylsilane, 1,3-disilabutane, bis(trimethylsilyl)methane, cyclopentadienyltrimethylsilane, phenyldimethylsilane, phenyltrimethylsilane, propargyltrimethylsilane, tetramethylsilane, trimethylsilylacetylene, 1-(trimethylsilyl)-1-propyne, tris(trimethylsilyl)methane, tris(trimethylsilyl)silane, vinyltrimethylsilane, hexamethyldisilane, octamethylcyclotetrasiloxane, tetramethylcyclotetrasiloxane, hexamethyldisiloxane, hexamethylcyclotetrasiloxane, and M-Silicate 51.

Further, the titanium compound is an inorganic titanium compound or an organic titanium compound. Examples of the inorganic titanium compound include titanium oxide and titanium chloride. Examples of the organic titanium compound include: titanium alkoxides such as titanium tetrabutoxide, tetra-n-butyl titanate, butyltitanate dimer, tetra(2-ethylhexyl) titanate, and tetramethyl titanate; and titanium chelates such as titanium lactate, titanium acetylacetonate, titanium tetraacetylacetonate, polytitanium acetylacetonate, titanium octylene glycolate, titanium ethylacetoacetate, and titanium triethanolaminate.

The formation of the thin film by the plasma CVD method may also be carried out by alternately or simultaneously forming the above-mentioned resin layer and the thin film including at least one kind selected from, for example, the inorganic material, inorganic oxide, and inorganic nitride.

The upper limit of the thickness of the above-mentioned plasma CVD thin film is preferably 5,000 nm, more preferably 500 nm, still more preferably 100 nm. Meanwhile, the lower limit thereof is 0.1 nm, preferably 0.5 nm. If the thickness is in the above-mentioned range, the film is preferred because the film is satisfactory in adhesion property, gas-barrier property, and the like. From the above-mentioned viewpoint, the thickness of the plasma CVD thin film is preferably 0.1 to 5,000 nm, more preferably 0.1 to 500 nm, still more preferably 0.1 to 100 nm. The formation of the plasma CVD thin film is preferably carried out under reduced pressure to form a dense thin film. The pressure in formation of the thin film is in the range of $1 \times 10^{-3}$ to $1 \times 10^{2}$ Pa, preferably $1 \times 10^{-2}$ to 10 Pa from the viewpoints of film formation speed and barrier property. The plasma CVD thin film may also be subjected to a cross-linking treatment by electron beam irradiation to enhance water resistance and durability.

The above-mentioned plasma CVD thin film may be formed by a method involving vaporizing the raw material compound, introducing the vapor as a raw material gas into a vacuum apparatus, and generating a plasma from the raw material gas with an apparatus for generating low temperature plasma of direct current (DC) plasma, low frequency plasma, radio frequency (RF) plasma, pulse wave plasma, tripolar plasma, microwave plasma, downstream plasma, columnar plasma, plasma-assisted epitaxy, or the like. From the viewpoint of plasma stability, a radio frequency (RF) plasma apparatus is more preferred.

[Step (3)]

The step (3) is a step of forming an inorganic thin film by the vacuum deposition method on the thin film formed in the step (2).

The vacuum deposition method and inorganic thin film formed by the method in the step (3) are the same as those in the step (1).

In the present invention, in view of improving barrier property, preferably, after formation of silicon oxide by the vacuum deposition method in the step (1), highly oxidized silicon oxide is formed by the plasma CVD method in the step (2). That is, preferably, the inorganic thin film formed by the vacuum deposition method in the step (1), or the steps (1) and (3) includes $SiOx_1$, where $x_1$ satisfies $1.2 \leq x1 \leq 1.9$, and the thin film formed by the plasma CVD method in the step (2) includes $SiOx_2$ where $x_2$ satisfies $1.5 \leq x_2 \leq 2.5$, and the thin films are formed so as to satisfy the relationship of $0.3 \leq x_2 - x1 \leq 1.3$. It is conceived that, when the thin film formed by the plasma CVD method is highly oxidized compared with the inorganic thin film formed by the vacuum deposition method, the thin film obtained by the deposition method can be effectively sealed. It should be noted that the measurement of the oxidation degree of silicon oxide described above is preferably carried out by X-ray photoelectron spectroscopy (XPS), specifically by the below-mentioned method.

[Film formation method]

In the present invention, the above-mentioned steps (1) to (3) are carried out sequentially under reduced pressure at a specific pressure in terms of the gas-barrier property and productivity. Moreover, from the same viewpoint, in the present invention, all the above-mentioned steps are preferably carried out in the same vacuum chamber preferably while the film is conveyed. That is, in the present invention, film formation is preferably carried out sequentially in a vacuum state instead of returning the pressure in the vacuum chamber to near an atmospheric pressure after completion of each of the steps and changing the pressure into a vacuum state again before the next steps.

FIG. 1 is a schematic explanatory view showing one example of a vacuum film formation device for carrying out the production method of the present invention.

As shown in FIG. 1, a vacuum film formation device 1 for producing a gas-barrier film has a feeding shaft 102 capable of feeding a web-like base film 101 while applying a constant back tension by torque control means such as a powder clutch, a winding shaft 103 having winding means capable of winding the film at a constant tension such as a torque motor, and tension rolls 104 equipped with tension detectors for an appropriate feedback, and film formation chambers 10, and in the film formation chambers 10, temperature-controlled film forming drums 105 and 106 for controlling the temperature of a film surface during film formation and forming a film on the film surface, a deposition heating source 107, and an electrode 108 for plasma CVD, which has a shower head for introducing a process gas or a raw material gas are arranged. FIG. 1 shows one example of a winding-type vacuum film formation device, but in the present invention, another batch-type film formation device may also be used.

In the above-mentioned vacuum film formation device, the production method includes: feeding the base film 101 from the feeding shaft 102; introducing the film into the film formation chamber 10; depositing a deposition film on the film base 101 from the deposition heating source 106 on the temperature-controlled film forming drum 105; conveying the film to the temperature-controlled film forming drum 106; forming a CVD thin film on the deposition film on the base film 101 using the electrode 108 for plasma CVD; and winding the film around the winding shaft 103. In the vacuum film formation device shown in FIG. 1, in the case where after the step (2), the step (3) is carried out, and the steps (2) and (3) are then repeated, the film may be wound back around the feeding shaft 102 once, and then film formation may be repeated in the same way as above, or a CVD thin film is further formed on the film using the electrode 108 for plasma CVD when the film is wound back around the feeding shaft 102, and then a deposition film may be deposited on the film using the deposition heating source 106. The above-mentioned procedures are carried out while the film is conveyed at a constant tension appropriately kept using the tension rolls 104, and each of the films is formed under reduced pressure. That is, in the present invention, film formation may be carried out sequentially under reduced pressure at a specific pressure, and it is not necessary to return the pressure to an atmospheric pressure between the film formation procedures.

In the present invention, very excellent gas-barrier property can be expressed by carrying out the steps (1) to (3) in the same vacuum chamber. Although the principle has not been clarified, conceivably, formation of the plasma CVD thin film in the same chamber as in formation of the inorganic thin film by the vacuum deposition can uniformly seal minor defects in the thin film formed by the deposition method and can further improve the gas-barrier property of a second deposition layer in the step (3).

In the present invention, the steps (2) and (3) are carried out after the step (1), and the above-mentioned steps (2) and (3) may be repeated once or more. In the present invention, the steps (2) and (3) are repeated preferably once to three times, more preferably once or twice in terms of quality stability.

It should be noted that in the case where the above-mentioned steps are repeated, the steps are preferably carried out sequentially in the same chamber under reduced pressure.

That is, in the present invention, a uniform thin film having high gas-barrier property can be obtained by carrying out the step (1). Moreover, the interlayer adhesion property in the multilayered inorganic thin film can be improved by carrying out the steps (2) and (3). In addition, if the steps (2) and (3) are repeated once or more, preferably once to three times, the gas-barrier property can be improved.

In the present invention, the pressure in each of the steps (1) and (3) is preferably lower than the pressure in the step (2) in terms of the degree of vacuum required for the gas-barrier performance obtained by densification of the inorganic thin film by the vacuum deposition method and the pressure essential for introduction of the organic compound required for a plasma chemical deposition method and plasma decomposition. Although there is no upper limit to the ratio and difference of the pressures, if the ratio and difference are too large, it becomes difficult to control the vacuum in the device.

From the above-mentioned viewpoint, the ratio of the pressure in the step (2) to the pressure in each of the steps (1) and (3) (the pressure in the step (2)/the pressure in each of the steps (1) and (3)) is preferably 10 to $1\times10^7$, more preferably $1\times10^2$ to $1\times10^6$, still more preferably $1\times10^2$ to $1\times10^5$.

From the same viewpoint, the pressure difference between the pressure in each of the steps (1) and (3) and the pressure in the step (2) is 0.001 Pa or more, more preferably 0.01 Pa or more. The upper limit of the pressure difference is not particularly limited, but is usually about 100 Pa from the relationship of the pressures in the vacuum deposition and plasma CVD.

[Anchor coat layer]

In the present invention, in order to improve adhesion between the base film and the inorganic thin film obtained by the vapor deposition method, it is preferred to form the anchor coat layer between the base film and the inorganic thin film by applying an anchor coating agent to the base film. As the anchor coating agent, from the viewpoint of productivity, an agent similar to the resin forming the resin layer as the plasma CVD thin film obtained by the above-mentioned step (2) can be used.

The thickness of the anchor coat layer formed on the base film is usually 0.1 to 5,000 nm, preferably 1 to 2,000 nm, more preferably 1 to 1,000 nm. When the thickness of the anchor coat layer is in the above-mentioned range, sliding property is satisfactory, the anchor coat layer hardly peels off from the base film due to the internal stress of the anchor coat layer itself, a uniform thickness can be maintained, and interlayer adhesion property is excellent.

Further, in order to improve coating property and adhesiveness of the anchor coating agent to the base film, the base film may be subjected to surface treatments such as a common chemical treatment and discharge treatment before the coating of the anchor coating agent.

[Protection layer]

Further, it is preferred for the gas-barrier film of the present invention to have a protection layer as an uppermost layer on a side having the thin film formed by the above-mentioned steps (1) to (3). As a resin forming the protection layer, both solvent resins and aqueous resins can be used. Specifically, polyester-based resins, urethane-based resins, acrylic resins, polyvinyl alcohol-based resins, ethylene-unsaturated carboxylic acid copolymer resins, ethylene vinyl alcohol-based resins, vinyl-modified resins, nitrocellulose-based resins, silicon-based resins, isocyanate-based resins, epoxy-based resins, oxazoline group-containing resins, modified styrene-based resins, modified silicon-based resins, alkyl titanates, and the like may be used alone, or two or more kinds thereof may be used in combination. Further, as the protection layer, in order to improve barrier property, abrasion property, and sliding property, it is preferred to use a layer obtained by mixing one or more kinds of inorganic particles selected from a silica sol, an alumina sol, a particulate inorganic filler, and a laminar inorganic filler in the one or more kinds of resins, or to use a layer containing a resin containing inorganic particles which is formed by polymerizing raw materials of the above-mentioned resin in the presence of the inorganic particles.

As a resin forming the protection layer, the above-mentioned aqueous resin is preferred from the viewpoint of improving gas-barrier property of the inorganic thin film. In addition, preferred as the aqueous resin are polyvinyl alcohol-based resins, ethylene vinyl alcohol-based resins, or ethylene-unsaturated carboxylic acid copolymer resins.

Hereinafter, the above-mentioned resin layers are described.

The polyvinyl alcohol-based resin can be obtained by a known method, and can be usually obtained by saponifying a polymer of vinyl acetate. The polyvinyl alcohol-based resin whose degree of saponification is 80% or more can be used. The degree of saponification is preferably 90% or more, more preferably 95% or more, particularly preferably 98% or more from the viewpoint of gas-barrier property.

The average degree of polymerization is usually 500 to 3,000, and is preferably 500 to 2,000 from the viewpoints of gas-barrier property and stretching property. Further, as polyvinyl alcohol, a product obtained by copolymerizing ethylene at a ratio of 40% or less can be used. An aqueous solution of polyvinyl alcohol can be prepared by, for example, supplying a polyvinyl alcohol resin while stirring in water at normal temperature, increasing the temperature, and stirring the resultant at 80 to 95°C for 30 to 60 minutes.

An ethylene-unsaturated carboxylic acid copolymer resin is a copolymer of ethylene with an unsaturated carboxylic acid such as acrylic acid, methacrylic acid, ethacrylic acid, fumaric acid, maleic acid, itaconic acid, monomethyl meleate, monoethyl maleate, maleic anhydride, or itaconic anhydride. Of those, a copolymer of ethylene with acrylic acid or methacrylic acid is preferred from the viewpoint of versatility. The ethylene-unsaturated carboxylic acid copolymer may contain any other monomer.

The content of the ethylene component in the ethylene-unsaturated carboxylic acid copolymer is preferably 65 to 90 mass%, more preferably 70 to 85 mass%, and the content of the unsaturated carboxylic acid component is preferably 10 to 35 mass%, more preferably 15 to 30 mass% from the viewpoints of versatility and plasticity. The melt flow rate (MFR) under a load of 2,160 g at 190°C of the above-mentioned ethylene-unsaturated carboxylic acid copolymer is preferably 30 to 2,000 g/10 minutes, more preferably 60 to 1,500 g/10 minutes from the viewpoint of bending resistance of a film. The number average molecular weight is preferably in the range of 2,000 to 250,000.

In the present invention, from the viewpoints of gas-barrier property, interlayer adhesion property, etc., it is preferred for the above-mentioned ethylene-unsaturated carboxylic acid copolymer to contain a partially neutralized substance thereof. The degree of neutralization of the partially neutralized substance is preferably 20 to 100%, more preferably 40 to 100%, particularly preferably 60 to 100% from the viewpoint of gas-barrier property. The degree of neutralization can be calculated according to the following equation.

$$\text{Degree of neutralization} = (A/B) \times 100 \, (\%)$$

A: Number of moles of a neutralized carboxyl group in 1 g of partially neutralized ethylene-unsaturated carboxylic acid copolymer
B: Number of moles of a carboxyl group in 1 g of ethylene-unsaturated carboxylic acid copolymer before partial neutralization

Note that, for convenience, in the case of an aqueous solution, the degree of neutralization can be calculated by, in the foregoing, defining A as a number obtained by (number of metal ions in a solvent)×(valence of the metal ions) and defining B as the number of carboxyl groups in the ethylene-unsaturated carboxylic acid copolymer before partial neutralization.

From the viewpoint of gas-barrier property, it is preferred to use the above-mentioned ethylene-unsaturated carboxylic acid copolymer in the form of an aqueous solution formed of the above-mentioned copolymer and an aqueous medium containing ammonia, sodium hydroxide, potassium hydroxide, lithium hydroxide, or the like. An aqueous solution containing the above-mentioned aqueous medium in such a manner that the degree of neutralization calculated with the above-mentioned equation is 20 to 100%, furthermore, 40 to 100%, with respect to the total number of moles of the carboxyl group contained in the ethylene-unsaturated carboxylic acid copolymer is preferably used.

In the present invention, the above-mentioned protection layer may be formed of one kind of the above-mentioned resins, or two or more kinds thereof may also be used in combination for the protection layer.

Further, inorganic particles can be added to the above-mentioned protection layer in order to improve barrier performance and adhesion property.

There is no particular limitation on inorganic particles used for the present invention, and, for example, any of known substances such as an inorganic filler, an inorganic laminar compound, and a metal oxide sol can be used.

Examples of the inorganic filler include oxides, hydroxides, hydrates, and carbonates of silicon, aluminum, magnesium, calcium, potassium, sodium, titanium, zinc, iron, and the like, and mixtures and composites thereof.

Examples of the inorganic laminar compound include clay minerals typified by a kaolinite group, a smectite group, a mica group, and the like. Of those, montmorillonite, hectorite, saponite, and the like may be used.

Examples of the metal oxide sol include metal oxides of silicon, antimony, zirconium, aluminum, cerium, titanium, and the like, and mixtures thereof. Of those, a substance containing a reactive functional group that can be subjected to hydrolysis condensation, such as a hydroxyl group or an alkoxy group, is preferred from the viewpoints of hot water resistance, gas-barrier property, and the like. In particular, a substance having a silanol group in the reactive functional group in a ratio of 10 to 100 mol% and furthermore, 20 to 100 mol% is preferably used.

In the present invention, silica particles are preferably used as the above-mentioned inorganic particles from the viewpoints of versatility and stability. The above-mentioned inorganic particles may be used alone, or two or more kinds thereof can be used in combination.

The average particle diameter of the inorganic particles has a lower limit of preferably 0.5 nm, more preferably 1 nm, and has an upper limit of preferably 2 $\mu$m, more preferably 200 nm, still more preferably 100 nm, still more preferably 25 nm, still more preferably 10 nm, still more preferably 5 nm from the viewpoints of hot water resistance and cohesive failure resistance. Specifically, the above-mentioned average particle diameter is preferably 0.5 to 2 $\mu$m, more preferably 0.5 to 200 nm, still more preferably 0.5 to 100 nm, still more preferably 0.5 to 25 nm, still more preferably 1 to 20 nm, still more preferably 1 to 10 nm, still more preferably 1 to 5 nm.

A thickness of the protection layer is preferably 0.05 to 10 $\mu$m, more preferably 0.1 to 3 $\mu$m from the viewpoints of printing performance and workability. A known coating method is suitably employed as a method of forming the protection layer. For example, any of methods such as reverse roll coater, gravure coater, rod coater, air doctor coater, and coating methods using a spray or a brush can be employed. The coating may also be performed by dipping a deposited film in a resin solution for a protection layer. After the coating, water can be evaporated using a known drying method such as drying by heating, e.g., hot-air drying at a temperature of about 80 to 200°C or heat roll drying, or infrared drying. Thus, a laminated film having a uniform coating layer is obtained.

[Structure of gas-barrier film of the present invention]

In view of gas-barrier property and adhesion property, the following modes are each preferably used for the gas-barrier film of the present invention.

(1) base film/AC/inorganic thin film/plasma CVD thin film/inorganic thin film
(2) base film/AC/inorganic thin film/plasma CVD thin film/inorganic thin film/plasma CVD thin film/inorganic thin film
(3) base film/AC/inorganic thin film/plasma CVD thin film/inorganic thin film/plasma CVD thin film/inorganic thin film/ plasma CVD thin film/inorganic thin film
(4) base film/AC/inorganic thin film/plasma CVD thin film/inorganic thin film/protection layer
(5) base film/AC/inorganic thin film/plasma CVD thin film/inorganic thin film/plasma CVD thin film/inorganic thin film/ protection layer

(6) base film/AC/inorganic thin film/plasma CVD thin film/inorganic thin film/plasma CVD thin film/inorganic thin film/ plasma CVD thin film/inorganic thin film/protection layer

(7) base film/inorganic thin film/plasma CVD thin film/inorganic thin film (8) base film/inorganic thin film/plasma CVD thin film/inorganic thin film/plasma CVD thin film/inorganic thin film

(9) base film/inorganic thin film/plasma CVD thin film/inorganic thin film/plasma CVD thin film/inorganic thin film/AC/ inorganic thin film

(10) base film/inorganic thin film/plasma CVD thin film/inorganic thin film/protection layer

(11) base film/inorganic thin film/plasma CVD thin film/inorganic thin film/plasma CVD thin film/inorganic thin film/ protection layer

(12) base film/inorganic thin film/plasma CVD thin film/inorganic thin film/plasma CVD thin film/inorganic thin film/ plasma CVD thin film/inorganic thin film/protection layer

(Note that AC denotes an anchor coat layer in the above-mentioned modes.)

In the present invention, various gas-barrier laminated films in which an additional constituent layer is, as required, further laminated on the above-mentioned constituent layers can be used according to the intended use. According to a common embodiment mode, a gas-barrier laminated film in which a plastic film is formed on the above-mentioned inorganic thin film or the above-mentioned protection layer is used for various applications. The thickness of the above-mentioned plastic film is selected from the range of usually 5 to 500 $\mu$m, preferably 10 to 200 $\mu$m according to the intended use from the viewpoints of mechanical strength, flexibility, transparency, etc., as the base of a laminated structure. Further, the width and length of the film are not particularly limited, and can be suitably selected according to the intended use. For example, by using a heat-sealable resin for the surface of the inorganic thin film or the protection layer, heat sealing becomes possible, whereby the present invention can be used as various containers. Examples of the heat-sealable resin include known resins such as a polyethylene resin, a polypropylene resin, an ethylene-vinyl acetate copolymer, an ionomer resin, an acrylic resin, and a biodegradable resin.

Moreover, according to another embodiment mode of the gas-barrier laminated film, a laminate in which a printing layer is formed on the coated surface of the inorganic thin film or the protection layer and a heat-seal layer is further laminated thereon is mentioned. As a printing ink for forming the printing layer, a printing ink containing an aqueous or solvent-based resin can be used. Here, mentioned as a resin used for the printing ink are acrylic resins, urethane-based resins, polyester-based resins, vinyl chloride-based resins, vinyl acetate copolymer resins, or mixtures thereof. Further, to the printing ink, known additives such as antistatic agents, light blocking agents, UV-absorbers, plasticizers, lubricants, fillers, colorants, stabilizers, lubricating agents, defoaming agents, cross-linking agents, anti-blocking agents, and antioxidants may be added.

There is no particular limitation on the printing method of preparing the printing layer, and known printing methods such as offset printing, gravure printing, and screen printing can be used. For drying the solvent after printing, known drying methods such as hot blow drying, hot roll drying, and infrared drying can be used.

Further, between the printing layer and the heat-seal layer, at least one layer of paper or a plastic film can be inserted. As the plastic film, a substance similar to the thermoplastic polymer film as a base film for use in the gas-barrier film of the present invention can be used. In particular, from the viewpoint of obtaining sufficient rigidity and strength of a laminate, paper, a polyester resin, a polyamide resin, or a biodegradable resin is preferred.

In the present invention, after the step (2), after the step (1) or (3), or after forming the protection layer, it is preferred to perform heat treatment from the viewpoints of, for example, gas-barrier property, stabilizing film qualities, and coated layer qualities.

Conditions of the heat treatment vary depending on types, thicknesses, and the like of components structuring a gas-barrier film. A heat treatment method is not particularly limited as long as the method can maintain a required temperature and time. For example, there may be employed: a method involving storing a film in an oven or a thermostat chamber whose temperature is set at a required temperature; a method involving applying hot blow to a film; a method involving heating a film with an infrared heater; a method involving irradiating a film with light using a lamp; a method involving directly providing heat to a film by bringing the film into contact with a hot roll or a hot plate; or a method involving irradiating a film with a microwave. Further, a film may be subjected to heat treatment after being cut to a dimension at which the handling thereof is facilitated, or a film roll may be subjected to heat treatment as it is. In addition, insofar as a required time and a required temperature can be achieved, heating can be carried out during a production process by installing a heating device in a part of a film production apparatus such as a coater or a slitter.

The heat treatment temperature is not particularly limited insofar as the temperature is equal to or lower than each melting point of a base, a plastic film, and the like, which are to be used. The heat treatment temperature is preferably 60°C or more, more preferably 70°C or more, considering the fact that a heat treatment time required for exhibiting a heat treatment effect can be suitably determined. The upper limit of the heat treatment temperature is usually 200°C, preferably 160°C from the viewpoint of preventing deterioration in gas-barrier property due to thermal decomposition of components structuring a gas-barrier film. The treatment time depends on a heat treatment temperature. As the treatment temperature is higher, the heat treatment time is preferably shorter. For example, when the heat treatment temperature is 60°C, the treatment time is about 3 days to 6 months, when the heat treatment temperature is 80°C, the treatment time is about 3 hours to 10 days, when the heat treatment temperature is 120°C, the treatment time is about 1 hour to 1 day, and when the heat treatment temperature is 150°C, the treatment time is about 3 minutes to 60 minutes. The above-mentioned heat treatment temperatures and heat treatment times are merely guides, and the heat treatment temperatures and the heat treatment times can be suitably adjusted depending on types, thicknesses, and the like of the components structuring a gas-barrier film.

<Gas-barrier film>

The present invention relates to a gas-barrier film including: a base film; (A) an inorganic thin film formed by the vacuum deposition method on at least one surface of the base film; and (B) at least one constituent unit layer including thin films successively formed by the plasma CVD method and the vacuum deposition method on the above-mentioned inorganic thin film (A), arranged in the stated order, preferably to a gas-barrier film in which the layers (A) and (B) are obtained sequentially under reduced pressure in the same vacuum chamber. In particular, a gas-barrier film obtained by the above-mentioned method for producing a gas-barrier film is preferred.
The inorganic thin film (A) formed by the vacuum deposition method on at least one surface of the base film is as mentioned above.

The constituent unit layer (B) including thin films successively formed by the plasma CVD method and the vacuum deposition method on the above-mentioned inorganic thin film (A) is as described in the steps (2) and (3) in the foregoing, and the gas-barrier film of the present invention has at least one constituent unit layer on the inorganic thin film provided on the base. However, in terms of the productivity, the gas-barrier film of the present invention has preferably one to three, more preferably one or two of the above-mentioned constituent unit layers on the inorganic thin film.
In addition, from the same viewpoint, lamination of the above-mentioned constituent unit layers is carried out preferably by providing two or more constituent unit layers successively in a repetitive manner, more preferably laminating a plasma CVD thin film as one constituent unit layer on the surface of the inorganic thin film as another constituent unit layer. In the present invention, another layer is optionally provided between the constituent unit layers.
In the gas-barrier film of the present invention, preferably, each of the inorganic thin films formed by the vacuum deposition method includes $SiOx_1$ ($1.2 \leq x1 \leq 1.9$), and the thin film formed by the plasma CVD method includes $SiOx_2$ ($1.5 \leq x_2 \leq 2.5$), and a relationship $0.3 \leq x_2 - x1 \leq 1.3$ is satisfied. Details thereof are as mentioned above.

Examples

Hereinafter, the present invention is specifically described by way of examples, but is not limited to the following examples. In the examples below, film evaluation methods are as follows.

<Water vapor permeability>

In accordance with the conditions stipulated in JIS Z0222 "Moisture permeability test for moisture-proof packaging container" and JIS Z0208 "Moisture permeability test for moisture-proof wrapping material (cup method)," water vapor permeability was determined through the following procedure.
In each analysis, a four-side-sealed bag was fabricated from two gas-barrier laminated films each having a moisture permeation area of 10.0 cm×10.0 cm, and about 20 g of calcium chloride anhydide serving as a hydroscopic agent was placed in the bag. The bag was placed in a thermo-hygrostat at a temperature of 40°C and a relative humidity of 90%, and weighed (precision: 0.1 mg) for 14 days at intervals of 48 hours or longer. A period of 14 days was selected, because weight is considered to increase at a constant rate within this period of time. Water vapor permeability was calculated from the following equation. Table 1-2 shows values of the water vapor permeability at day 3.

$$\text{Water vapor permeability } (g/m^2/24\ h)=(m/s)/t,$$

where parameters are as follows:

m: increase in mass (g) between the last two measurements in the test;
s: moisture permeation area ($m^2$); and
t: duration (h)/24 (h) between the last two measurements in the test.

<Interlayer adhesion property>

In accordance with JIS Z1707, a laminated film was cut into a strip of 15 mm wide. An end part of the strip was partially peeled. T-type peeling was performed by subjecting the end part of the strip to a peel tester at a rate of 300 mm/minute to measure laminate strength (g/15 mm).

<Thickness of thin film>

The resultant laminated film was embedded in a resin to prepare an ultrathin section of its cross-sectional surface, and the cross-sectional surface was observed using a transmission electron microscope to determine the thickness of each layer.

<Oxidation degree $x_1$, $x_2$ of silicon oxide >

A thin film was etched by X-ray photoelectron spectroscopy (XPS) to determine an atom percent ratio (A) of an O1s spectrum to an Si2p spectrum. On the other hand, an $SiO_2$ tablet was etched and subjected to a spectrum analysis under the same conditions to determine its atom percent ratio (B) of an Ols spectrum to an Si2p spectrum, and (A)$\times$2.0/(B) was calculated to determine $x_1$ and $x_2$ values.

Example 1

A polyethylene terephthalate resin (hereinafter, abbreviated as "PET;" "Novapex" manufactured by Mitsubishi Chemical Corporation) was melt-extruded to thereby form a sheet. By stretching the sheet in a longitudinal direction at a stretching temperature of 95°C at a stretching ratio of 3.3, and then stretching the sheet in a transverse direction at a stretching temperature of 110°C at a stretching ratio of 3.3, a biaxially stretched PET film having a thickness of 12 $\mu$m was obtained. A mixture of an isocyanate compound ("Coronate L" manufactured by Nippon Polyurethane Industry Co., Ltd.) and a saturated polyester ("VYLON 300" manufactured by Toyobo Co., Ltd., number average molecule weight: 23,000) mixed at a mass ratio of 1:1 was coated on one surface of the film, followed by drying to form an anchor coat layer having a thickness of 100 nm.
Subsequently, SiO was evaporated by a high frequency heating method under a vacuum of $1\times10^{-3}$ Pa using a vacuum deposition device, thereby forming an inorganic thin film having a thickness of 30 nm (SiOx:x=1.6, sometimes referred to as "first deposition layer") on the anchor coat layer.
Subsequently, HMDSO (hexamethyldisiloxane) and oxygen were fed at a molar ratio of 1:4 into the same vacuum deposition device without returning the pressure to an atmospheric pressure, and formed into a plasma under a vacuum of 1 Pa at 13.56 MHz and 1 Kw to form a plasma CVD film (SiOxC:x=2.0) (thickness: 10 nm) on the inorganic thin film surface.
Subsequently, SiO was evaporated by a high frequency heating method under a vacuum of $1\times10^{-3}$ Pa in the same vacuum deposition device without returning the pressure to an atmospheric pressure, thereby forming an inorganic thin film having a thickness of 30 nm (SiOx:x=1.6, sometimes referred to as "second deposition layer") on the plasma CVD film.
On the surface having the inorganic thin film of the resultant film, an urethane-based adhesive ("AD900" and "CAT-RT85" manufactured by Toyo-Morton, Ltd. were mixed in a ratio of 10:1.5) was further coated, followed by drying, thereby forming an adhesive resin layer having a thickness of about 3 $\mu$ m. On the adhesive resin layer, a unstretched polypropylene film having a thickness of 60 $\mu$m ("Pylen Film CT P1146" manufactured by Toyobo Co., Ltd.) was laminated to obtain a laminated film. The resultant laminated film was subjected to the above-mentioned evaluations. Table 1-1 and Table 1-2 show the results.

Example 2

A laminated film was prepared by the same procedure as in Example 1 except that HMDS (hexamethyldisilazane) and nitrogen were fed at a molar ratio of 1:4 to form a plasma CVD film (SiOxNC:x=2.2). The resultant laminated film was subjected to the above-mentioned evaluations. Table 1-1 and Table 1-2 show the results.

Example 3

A laminated film was prepared in the same procedure as in Example 2 except that the thickness of the plasma CVD film was adjusted to 30 nm. The resultant laminated film was subjected to the above-mentioned evaluations. Table 1-1 and Table 1-2 show the results.

Example 4

A laminated film was prepared by the same procedure as in Example 1 except that the thicknesses of the inorganic thin film on the anchor coat layer and the inorganic thin film on the plasma CVD film were each adjusted to 100 nm, and formation of the plasma CVD film was carried out by feeding HMDSO (hexamethyldisiloxane) and nitrogen at a molar ratio of 1:4 to form a plasma CVD film having a thickness of 30 nm (SiOxNC:x= 2.0). The resultant laminated film was subjected to the above-mentioned evaluations. Table 1-1 and Table 1-2 show the results.

Example 5

A laminated film was prepared by the same procedure as in Example 1 except that an inorganic thin film having a thickness of 100 nm was formed on the anchor coat layer, HMDSO (hexamethyldisiloxane) and nitrogen were then fed at a molar ratio of 1:4 to form a plasma CVD film having a thickness of 30 nm (SiOxNC:x=2.0), the thickness of the inorganic thin film on the plasma CVD film was adjusted to 100 nm, and a top coating was provided. The top coating (also referred to as TC or protecting layer) was obtained by applying and drying a solution prepared by mixing an aqueous solution of polyvinyl alcohol having an average polymerization degree of 3,000 and a saponification degree of 98% and an aqueous dispersion of an ethylene-methacrylic acid copolymer having a weight-average molecular weight of 70,000 (degree of neutralization with sodium hydroxide: 50%) so as to achieve a solid content ratio of 40:60 on the second inorganic thin film to have a solid content thickness of 0.3 $\mu$m. The resultant laminated film was subjected to the above-mentioned evaluations. Table 1-1 and Table 1-2 show the results.

Example 6

A laminated film was prepared by the same procedure as in Example 1 except that acetylene gas was fed so as to achieve a pressure of 10 Pa in the vacuum chamber in formation of the plasma CVD film to form a diamond like carbon film having a thickness of 10 nm. The resultant laminated film was subjected to the above-mentioned evaluations. Table 1-1 and Table 1-2 show the results.

Example 7

A laminated film was prepared by the same procedure as in Example 1 except that a mixture obtained by blending an isocyanate compound ("CORONATE L" manufactured by NIPPON POLYURETHANE INDUSTRY CO., LTD.) and an acrylic resin ("Paraloid B66" manufactured by Rohm and Haas) at a weight ratio of 1:1 in formation of the plasma CVD film was vaporized and fed into the vacuum chamber to form a thin film having a thickness of 0.1 nm, to thereby prepare. The resultant laminated film was subjected to the above-mentioned evaluations. Table 1-1 and Table 1-2 show the results.

Example 8

A laminated film was prepared by the same procedure as in Example 7 except that a plasma CVD film having a thickness of 30 nm was formed. The resultant laminated film was subjected to the above-mentioned evaluations. Table 1-1 and Table 1-2 show the results.

Example 9

A laminated film was prepared by the same procedure as in Example 7 except that a plasma CVD film having a thickness of 300 nm was formed. The resultant laminated film was subjected to the above-mentioned evaluations. Table 1-1 and Table 1-2 show the results.

Example 10

A laminated film was prepared by the same procedure as in Example 1 except that 1,3-bis(isocyanatomethyl) cyclohexane and methylenebis(4-cyclohexylamine) were fed in formation of the plasma CVD film to form a polyurea film having a thickness of 30 nm. The resultant laminated film was subjected to the above-mentioned evaluations. Table 1-1 and Table 1-2 show the results.

Example 11

A laminated film was prepared by the same procedure as in Example 1 except that diphenylmethane-4,4'-diisocyanate was fed in formation of the plasma CVD film to form a polyisocyanate film being formed of a polymerized product of diphenylmethane-4,4'-diisocyanate and having a thickness of 30 nm. The resultant laminated film was subjected to the above-mentioned evaluations. Table 1-1 and Table 1-2 show the results.

Example 12

A laminated film was prepared by the same procedure as in Example 1 except that di-p-xylylene was vaporized and fed into the vacuum chamber in formation of the plasma CVD film to form a thin film having a thickness of 30 nm. The resultant laminated film was subjected to the above-mentioned evaluations. Table 1-1 and Table 1-2 show the results.

Example 13

In Example 1, before lamination of the unstretched polypropylene film with the adhesive resin layer, a plasma CVD film was further formed on the surface of the inorganic thin film on the plasma CVD film and an inorganic thin film was formed on the plasma CVD film under the same conditions as those for the plasma CVD film and inorganic thin film. Thus, a laminated film was prepared, and the resultant film was subjected to the above-mentioned evaluations. Table 1-1 and Table 1-2 show the results.

Example 14

A laminated film was prepared by the same procedure as in Example 1 except that a reaction product of 1,3-bis(N,N'-diglycidylaminomethyl)benzene and m-xylylene diamine was fed in formation of the plasma CVD film to form a film having a thickness of 30 nm. The resultant laminated film was subjected to the above-mentioned evaluations. Table 1-1 and Table 1-2 show the results.

Examples 15 to 20

A laminated film was prepared by the same procedure as in Example 1 except that the film was formed with changes in the pressure in vacuum deposition and the pressure in plasma CVD as shown in Table 1-1. The resultant laminated film was subjected to the above-mentioned evaluations. Table 1-1 and Table 1-2 show the results.

Comparative Example 1

A laminated film was prepared by the same procedure as in Example 1 except that only the inorganic thin film having a thickness of 30 nm was formed on the anchor coat layer, and the plasma CVD film and inorganic thin film were not formed thereon. The resultant laminated film was subjected to the above-mentioned evaluations. Table 1-1 and Table 1-2 show the results.

Comparative Example 2

A laminated film was prepared by the same procedure as in Example 1 except that the inorganic thin film was formed directly on the inorganic thin film layer without forming the plasma CVD film. The resultant laminated film was subjected to the above-mentioned evaluations. Table 1-1 and Table 1-2 show the results.

Comparative Example 3

A laminated film was prepared by the same procedure as in Example 1 except that the inorganic thin film was not formed on the formed plasma CVD film. The resultant laminated film was subjected to the above-mentioned evaluations. Peeling-off occurred near the interface between the plasma CVD film and the adhesive. Table 1-1 and Table 1-2 show the results.

Comparative Example 4

In Example 1, the inorganic thin film (SiOx:x=1.6) was formed on the plasma CVD film by: returning the pressure to an atmospheric pressure after formation of the plasma CVD film; opening the door of the vacuum chamber; and vaporizing SiO in the same vacuum deposition device under a vacuum of a pressure of $1\times10^{-3}$ Pa by a high frequency heating method. Subsequently, in the same way as in Example 1, the unstretched polypropylene film was laminated with the adhesive resin layer, to thereby prepare a laminated film, and the resultant laminated film was subjected to the above-mentioned evaluations. Table 1-1 and Table 1-2 show the results.

Comparative Examples 5 to 7

A laminated film was prepared by the same procedure as in Example 1 except that the film was formed with changes in the pressure in vacuum deposition and the pressure in plasma CVD as shown in Table 1-1. The resultant laminated film was subjected to the above-mentioned evaluations.
In Comparative Example 5, plasma CVD could not be achieved because the vacuum in the first deposition required high evacuation ability and long time. In Comparative Example 6, after film formation, the first deposition film was peeled off from the base film, and hence measurement and analysis of the inorganic thin film could not be carried out. Meanwhile, in Comparative Example 7, inside of the plasma CVD device was very dirty, and winding film formation could not be carried out.
[Table 1]

Table 1-1

| | Layer structure | First and second deposition pressure [Pa] | Plasma CVD pressure [Pa] | Pressure ratio | Thickness of first deposited layer [nm] | Thickness of plasma CVD layer [nm] | Thickness of second deposited layer [nm] |
|---|---|---|---|---|---|---|---|
| Example 1 | PET/SiO$_{x1}$/Plasma CVD (SiO$_{x2}$C) /SiO$_{x1}$//CPP | $1 \times 10^{-3}$ | 1 | $1 \times 10^3$ | 30 | 10 | 30 |
| Example 2 | PET/SiO$_{x1}$/Plasma CVD (SiO$_{x2}$NC) /SiO$_{x1}$//CPP | $1 \times 10^{-3}$ | 1 | $1 \times 10^3$ | 30 | 10 | 30 |
| Example 3 | PET/SiO$_{x1}$/Plasma CVD (SiO$_{x2}$NC) /SiO$_{x1}$//CPP | $1 \times 10^{-3}$ | 1 | $1 \times 10^3$ | 30 | 30 | 30 |
| Example 4 | PET/SiO$_{x1}$/Plasma CVD (SiO$_{x2}$NC) /SiO$_{x1}$//CPP | $1 \times 10^{-3}$ | 1 | $1 \times 10^3$ | 100 | 30 | 100 |
| Example 5 | PET/SiO$_{x1}$/Plasma CVD (SiO$_{x2}$NC) /SiO$_{x1}$/TC//CPP | $1 \times 10^{-3}$ | 1 | $1 \times 10^3$ | 100 | 30 | 100 |
| Example 6 | PET/SiO$_{x1}$/Plasma CVD (DLC)/SiO$_{x1}$//CPP | $1 \times 10^{-3}$ | 1 | $1 \times 10^3$ | 30 | 10 | 30 |
| Example 7 | PET/SiO$_{x1}$/Plasma CVD (acrylic) /SiO$_{x1}$//CPP | $1 \times 10^{-3}$ | 1 | $1 \times 10^3$ | 30 | 0.1 | 30 |
| Example 8 | PET/SiO$_{x1}$/Plasma CVD (acrylic) /SiO$_{x1}$//CPP | $1 \times 10^{-3}$ | 1 | $1 \times 10^3$ | 30 | 30 | 30 |
| Example 9 | PET/SiO$_{x1}$/Plasma CVD (acrylic) /SiO$_{x1}$//CPP | $1 \times 10^{-3}$ | 1 | $1 \times 10^3$ | 30 | 300 | 30 |
| Example 10 | PET/SiO$_{x1}$/Plasma CVD (polyurea) /SiO$_{x1}$//CPP | $1 \times 10^{-3}$ | 1 | $1 \times 10^{-3}$ | 30 | 30 | 30 |

| | Layer structure | First and second deposition pressure [Pa] | Plasma CVD pressure [Pa] | Pressure ratio | Thickness of first deposited layer [nm] | Thickness of plasma CVD layer [nm] | Thickness of second deposited layer [nm] |
|---|---|---|---|---|---|---|---|
| Example 11 | PET/SiO$_{x1}$/Plasma CVD (isocyanate) /SiO$_{x1}$//CPP | $1\times10^{-3}$ | 1 | $1\times10^{3}$ | 30 | 30 | 30 |
| Example 12 | PET/SiO$_{x1}$/Plasma CVD (Poly-p-xylylene) /SiO$_{x1}$//CPP | $1\times10^{-3}$ | 1 | $1\times10^{3}$ | 30 | 30 | 30 |
| Example 13 | PET/SiO$_{x1}$/Plasma CVD (SiO$_{x2}$C)/SiO$_{x1}$/ plasma CVD (SiO$_{x2}$C) /SiO$_{x1}$//CPP | $1\times10^{-3}$ | 1 | $1\times10^{3}$ | 30 | 10 | 30 |
| Example 14 | PET/SiO$_{x1}$/Plasma CVD (m-xylylene-based epoxy *) /SiO$_{x1}$//CPP | $1\times10^{-3}$ | 1 | $1\times10^{3}$ | 30 | 30 | 30 |
| Example 15 | PET/SiO$_{x1}$/Plasma CVD (SiO$_{x2}$C) /SiO$_{x1}$//CPP | $1\times10^{-6}$ | 1 | $1\times10^{6}$ | 30 | 10 | 30 |
| Example 16 | PET/SiO$_{x1}$/Plasma CVD (SiO$_{x2}$C) /SiO$_{x1}$//CPP | $1\times10^{-5}$ | 1 | $1\times10^{5}$ | 30 | 10 | 30 |
| Example 17 | PET/SiO$_{x1}$/Plasma CVD (SiO$_{x2}$C) /SiO$_{x1}$//CPP | $1\times10^{-1}$ | 1 | 10 | 30 | 10 | 30 |
| Example 18 | PET/SiO$_{x1}$/Plasma CVD (SiO$_{x2}$C) /SiO$_{x1}$//CPP | $1\times10^{-3}$ | $1\times10^{-2}$ | 10 | 30 | 10 | 30 |
| Example 19 | PET/SiO$_{x1}$/Plasma CVD (SiO$_{x2}$C) /SiO$_{x1}$//CPP | $1\times10^{-3}$ | $1\times10^{+3}$ | $1\times10^{5}$ | 30 | 10 | 30 |

(continued)

| | Layer structure | First and second deposition pressure [Pa] | Plasma CVD pressure [Pa] | Pressure ratio | Thickness of first deposited layer [nm] | Thickness of plasma CVD layer [nm] | Thickness of second deposited layer [nm] |
|---|---|---|---|---|---|---|---|
| Example 20 | PET/SiO$_{x1}$/Plasma CVD (SiO$_{x2}$C) /SiO$_{x1}$//CPP | $1\times10^{-1}$ | $1\times10^{-3}$ | $1\times10^{6}$ | 30 | 10 | 30 |
| Comparative Example 1 | PET/SiO$_{x1}$//CPP | $1\times10^{-3}$ | 1 | $1\times10^{3}$ | 30 | - | - |
| Comparative Example 2 | PET/SiO$_{x1}$/SiO$_{x1}$//CPP | $1\times10^{-3}$ | 1 | $1\times10^{3}$ | 30 | 0 | 30 |
| Comparative Example 3 | PET/SiO$_{x1}$/Plasma CVD (SiO$_{x2}$C)//CPP | $1\times10^{-3}$ | 1 | $1\times10^{3}$ | 30 | 300 | 0 |
| Comparative Example 4 | PET/SiO$_{x1}$/Plasma CVD (SiO$_{x2}$C) /SiO$_{x1}$//CPP | $1\times10^{-3}$ | 1 | $1\times10^{3}$ | 30 | 10 | 30 |
| Comparative Example 5 | PET/SiO$_{x1}$/Plasma CVD (SiO$_{x2}$C) /SiO$_{x1}$//CPP | $1\times10^{-8}$ | - | - | - | - | - |
| Comparative Example 6 | PET/SiO$_{x1}$|Plasma CVD (SiO$_{x2}$C) /SiO$_{x1}$//CPP | 10 | 1 | $1\times10^{-1}$ | - | - | - |
| Comparative Example | 7 PET/SiO$_{x1}$/Plasma CVD (SiO$_{x2}$C) /SiO$_{x1}$//CPP | $1\times10^{-3}$ | $1\times10^{3}$ | $1\times10^{6}$ | - | - | - |

* TC represents a top coat layer, and // represents an adhesive layer.
* m-Xylylene-based epoxy: a reaction product of 1,3-bistN,N'-diglycidylaminomethyl)benzene and m-xylylene diamine

[Table 2]

Table 1-2

| | | Inorganic thin film [$x_1$] [-] | Plasma CVD film [$x_2$] [-] | $x_2 - x_1$ | Transmission of water vapor [g/m²/24 hr] | Adhesion strength [g/15 mm] |
|---|---|---|---|---|---|---|
| Example 1 | PET/SiO$_{x1}$/Plasma CVD (SiO$_{x2}$C)/SiO$_{x1}$//CPP | 1.6 | 2.0 | 0.4 | 0.040 | 620 |
| Example 2 | PET/SiO$_{x1}$/Plasma CVD (SiO$_{x2}$NC)/SiO$_{x1}$//CPP | 1.6 | 2.2 | 0.6 | 0.020 | 590 |
| Example 3 | PET/SiO$_{x1}$/Plasma CVD (SiO$_{x2}$NC)/SiO$_{x1}$//CPP | 1.6 | 2.2 | 0.6 | 0.010 | 550 |
| Example 4 | PET/SiO$_{x1}$/Plasma CVD (SiO$_{x2}$NC)/SiO$_{x1}$//CPP | 1.6 | 2.0 | 0.4 | 0.007 | 520 |
| Example 5 | PET/SiO$_{x1}$/Plasma CVD (SiO$_{x2}$NC)/SiO$_{x1}$/TC//CPP | 1.6 | 2.0 | 0.4 | 0.003 | 560 |
| Example 6 | PET/SiO$_{x1}$/Plasma CVD (DLC)/SiO$_{x1}$//CPP | 1.6 | - | - | 0.030 | 340 |
| Example 7 | PET/SiO$_{x1}$/Plasma CVD (acrylic)/SiO$_{x1}$/CPP | 1.6 | - | - | 0.060 | 580 |
| Example 8 | PET/SiO$_{x1}$/Plasma CVD (acrylic)/SiO$_{x1}$//CPP | 1.6 | - | - | 0.050 | 440 |
| Example 9 | PET/SiO$_{x1}$/Plasma CVD (acrylic)/SiO$_{x1}$//CPP | 1.6 | - | - | 0.020 | 300 |
| Example 10 | PET/SiO$_{x1}$/Plasma CVD (polyurea)/SiO$_{x1}$//CPP | 1.6 | - | - | 0.050 | 340 |
| Example 11 | PET/SiO$_{x1}$/Plasma CVD (isocyanate)/SiO$_{x1}$//CPP | 1.6 | - | - | 0.040 | 480 |
| Example 12 | PET/SiO$_{x1}$Plasma CVD (poly-p-xylylene)/SiO$_{x1}$//CPP | 1.6 | - | - | 0.060 | 520 |
| Example 13 | PET/SiO$_{x1}$/Plasma CVD (SiO$_{x2}$C)/SiO$_{x1}$/plasma CVD (SiO$_{x2}$c)/Sio$_{x1}$//CPP | 1.6 | 2.0 | 0.4 | 0.020 | 530 |
| Example 14 | PET/SiO$_{x1}$/Plasma CVD (m-xylylene epoxy)/SiO$_{x1}$//CPP | 1.6 | - | - | 0.020 | 320 |

(continued)

| | | Inorganic thin film [$x_1$] [-] | Plasma CVD film [$x_2$] [-] | $x_2$-$x_1$ | Transmission of water vapor [g/m$^2$/24 hr] | Adhesion strength [g/15 mm] |
|---|---|---|---|---|---|---|
| | Layer structure | | | | | |
| Example 15 | PET/SiO$_{x1}$/Plasma CVD (SiO$_{x2}$C) /SiO$_{x1}$//CPP | 1.3 | 2.0 | 0.7 | 0.020 | 590 |
| Example 16 | PET/SiO$_{x1}$/Plasma CVD (BiO$_{x2}$C) /SiO$_{x1}$//CPP | 1.4 | 2.0 | 0.6 | 0.010 | 550 |
| Example 17 | PET/SiO$_{x1}$/Plasma CVD (SiO$_{x2}$C) /SiO$_{x1}$//CPP | 1.7 | 2.0 | 0.3 | 0.007 | 520 |
| Example 18 | PET/SiO$_{x1}$/Plasma CVD (SiO$_{x2}$C) /SiO$_{x1}$//CPP | 1.6 | 1.9 | 0.3 | 0.003 | 560 |
| Example 19 | PET/SiO$_{x1}$/Plasma CVD (SiO$_{x2}$C) /SiO$_{x1}$//CPP | 1.6 | 2.3 | 0.7 | 0.030 | 340 |
| Example 20 | PET/SiO$_{x1}$/Plasma CVD (SiO$_{x2}$C) /SiO$_{x1}$//CPP | 1.7 | 1.8 | 0.1 | 0.060 | 580 |
| Comparative Example 1 | PET/SiO$_{x1}$//CPP | 1.6 | - | - | 0.340 | 530 |
| Comparative Example 2 | PET/SiO$_{x1}$/SiO$_{x1}$//CPP | 1.6 | - | - | 0.250 | 510 |
| Comparative Example 3 | PET/SiO$_{x1}$/plasma CVD (SiO$_{x2}$C)//CPP | 1.6 | 2.0 | 0.4 | 0.120 | 10 |
| Comparative Example 4 | PET/SiO$_{x1}$/plasma CVD (SiO$_{x2}$C) /SiO$_{x1}$//CPP | 1.6 | 2.0 | 0.4 | 0.300 | 480 |
| Comparative Example 5 | PET/SiO$_{x1}$/plasma CVD (SiO$_{x2}$C) /SiO$_{x1}$//CPP | - | - | - | - | - |
| Comparative Example 6 | PET/SiO$_{x1}$/plasma CVD (SiO$_{x2}$C) /SiO$_{x1}$//CPP | - | - | - | - | - |
| Comparative Example 7 | PET/SiO$_{x1}$plasma CVD (SiO$_{x2}$C)/SiO$_{x1}$/CPP | - | - | - | - | - |
| * TC represents a top coat layer. * // represents an adhesive layer. | | | | | | |

Industrial Applicability

The gas-barrier film obtained by the production method of the present invention is widely used as a wrapping material for articles which require blocking of various gases such as water vapor and oxygen, for example, a wrapping material for preventing deterioration of foods, industrial goods, drugs, and the like. Moreover, in addition to the wrapping use, the gas-barrier film of the present invention can also be suitably used as a transparent conductive sheet which is used for liquid crystal display devices, solar cells, electromagnetic wave shields, touch panels, EL substrates, color filters, and the like.

**Claims**

1. A method for producing a gas-barrier film, comprising the steps of: (1) forming an inorganic thin film by a vacuum deposition method on at least one surface of a base film; (2) forming a thin film by a plasma CVD method on the inorganic thin film formed in the step (1); and (3) forming an inorganic thin film by the vacuum deposition method on the thin film formed in the step (2), wherein each of the steps (1) and (3), and the step (2) are sequentially carried out at a pressure of $1 \times 10^{-7}$ to 1 Pa, and at a pressure of $1 \times 10^{-3}$ to $1 \times 10^2$ Pa, respectively.

2. The method for producing a gas-barrier film according to claim 1, wherein the pressure in each of the steps (1) and (3) is lower than the pressure in the step (2).

3. The method for producing a gas-barrier film according to claim 1 or 2, wherein a ratio of the pressure in the step (2) to the pressure in each of the steps (1) and (3) (the pressure in the step (2)/the pressure in each of the steps (1) and (3)) is 10 to $1 \times 10^7$.

4. The method for producing a gas-barrier film according to any one of claims 1 to 3, wherein the steps (2) and (3) are repeated once to three times.

5. The method for producing a gas-barrier film according to any one of claims 1. to 4, wherein the steps (1) to (3) are carried out in the same vacuum chamber.

6. The method for producing a gas-barrier film according to any one of claims 1 to 5, wherein the thin film obtained by the plasma CVD method in the step (2) comprises at least one kind selected from an inorganic material, an inorganic oxide, and an inorganic nitride.

7. The method for producing a gas-barrier film according to any one of claims 1 to 6, wherein each of the thin films formed by the vacuum deposition method comprises $SiOx_1$ where $x_1$ satisfies $1.2 \leq x_1 \leq 1.9$, the thin film formed by the plasma CVD method comprises $SiOx_2$ where $x_2$ satisfies $1.5 \leq x_2 \leq 2.5$, and a relationship $0.3 \leq x_2 - x_1 \leq 1.3$ is satisfied.

8. The method for producing a gas-barrier film according to any one of claims 1 to 7, wherein the thin film obtained by the plasma CVD method in the step (2) comprises at least one kind selected from the group consisting of a polyester-based resin, a urethane-based resin, an acrylic resin, an epoxy-based resin, a nitrocellulose-based resin, a silicon-based resin, an isocyanate-based resin, and a poly-p-xylylene resin.

9. The method for producing a gas-barrier film according to any one of claims 1 to 8, further comprising the step of forming, on the base film, an anchor coat layer including at least one kind of resin selected from the group consisting of a polyester-based resin, a urethane-based resin, an acrylic resin, a nitrocellulose-based resin, a silicon-based resin, and an isocyanate-based resin.

10. The method for a gas-barrier film according to any one of claims 1 to 9, further comprising the step of providing a protection layer as an uppermost layer.

11. The method for producing a gas-barrier film according to claim 10, wherein the protection layer comprises at least one kind of resin selected from polyvinyl alcohol, ethylene vinyl alcohol, and an ethylene-unsaturated carboxylic acid copolymer.

12. A gas-barrier film, comprising: a base film; (A) an inorganic thin film formed by a vacuum deposition method on at least one surface of the base film; and (B) at least one constituent unit layer including thin films formed successively by a plasma CVD method and the subsequent vacuum deposition method on the inorganic thin film (A), arranged in the stated order.

13. The gas-barrier film according to claim 12, wherein the layer (A) and the layer (B) are sequentially obtained in the same vacuum chamber under reduced pressure.

14. The gas-barrier film according to claim 12 or 13, wherein each of the thin films formed by the vacuum deposition method comprises $SiOx_1$ where $x_1$ satisfies $1.2 \leq x_1 \leq 1.9$, the thin film formed by the plasma CVD method comprises $SiOx_2$ where $x_2$ satisfies $1.5 \leq x_2 \leq 2.5$, and a relationship $0.3 \leq x_2 - x_1 \leq 1.3$ is satisfied.

**15.** A gas-barrier film, which is obtained by the production method according to any one of claims 1 to 11.

**INTERNATIONAL SEARCH REPORT**

| International application No. |
| --- |
| PCT/JP2010/052219 |

A. CLASSIFICATION OF SUBJECT MATTER
*C23C14/08*(2006.01)i, *B32B9/00*(2006.01)i, *C23C14/56*(2006.01)i, *C23C16/40*
(2006.01)i, *C23C16/54*(2006.01)i

According to International Patent Classification (IPC) or to both national classification and IPC

B. FIELDS SEARCHED

Minimum documentation searched (classification system followed by classification symbols)
C23C14/00-14/58, C23C16/00-16/56, B32B9/00

Documentation searched other than minimum documentation to the extent that such documents are included in the fields searched
Jitsuyo Shinan Koho          1922-1996   Jitsuyo Shinan Toroku Koho   1996-2010
Kokai Jitsuyo Shinan Koho    1971-2010   Toroku Jitsuyo Shinan Koho   1994-2010

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
| --- | --- | --- |
| X<br>Y | JP 2007-136800 A  (Fujifilm Corp.),<br>07 June 2007 (07.06.2007),<br>claims; paragraphs [0024] to [0035], [0060] to<br>[0062]<br>(Family: none) | 1-8,12,13,15<br>9-11 |
| Y | JP 2007-210262 A  (Dainippon Printing Co.,<br>Ltd.),<br>23 August 2007 (23.08.2007),<br>claims 1 to 4; paragraphs [0010], [0016] to<br>[0018]<br>(Family: none) | 9-11 |

☒  Further documents are listed in the continuation of Box C.          ☐  See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>07 May, 2010 (07.05.10) | Date of mailing of the international search report<br>18 May, 2010 (18.05.10) |
| --- | --- |
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2010/052219

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2007-098679 A (Dainippon Printing Co., Ltd.), 19 April 2007 (19.04.2007), claims 1, 4; paragraphs [0009], [0023], [0053] to [0056] (Family: none) | 9-11 |
| X | JP 2003-266584 A (Mitsubishi Plastics, Inc.), 24 September 2003 (24.09.2003), paragraphs [0019] to [0025] (Family: none) | 12-15 |
| X | JP 06-128725 A (Mitsubishi Kasei Corp.), 10 May 1994 (10.05.1994), paragraphs [0020] to [0032] (Family: none) | 12-15 |
| A | JP 2003-181974 A (Toppan Printing Co., Ltd.), 03 July 2003 (03.07.2003), entire text (Family: none) | 1-15 |
| A | JP 2005-035204 A (Oike & Co., Ltd.), 10 February 2005 (10.02.2005), entire text (Family: none) | 1-15 |
| A | JP 2006-239883 A (Fuji Photo Film Co., Ltd.), 14 September 2006 (14.09.2006), entire text & US 2006/0204772 A1 | 1-15 |

Form PCT/ISA/210 (continuation of second sheet) (July 2009)

27

**EP 2 397 574 A1**

| INTERNATIONAL SEARCH REPORT | International application No. |
|---|---|
| | PCT/JP2010/052219 |

**Box No. II      Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III      Observations where unity of invention is lacking (Continuation of item 3 of first sheet)**

This International Searching Authority found multiple inventions in this international application, as follows:

```
   The invention in claim 1 cannot be deemed to have a substantial novelty,
and the invention in claim 2 dependent on claim 1 can be deemed to have a
special technical feature.
   Therefore, this application is considered to involve a plurality of invention
groups comprising the invention in claim 2 including all of the matters to
define the invention described in claim 1, and the main invention constituted
of the invention dependent on claim 2; and other inventions which are not
dependent on claim 2 including all of the matters to define the invention
described in claim 1.
```

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**          ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

28

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003071968 A
- JP 2003231202 A
- JP 2004114645 A
- JP 2003257619 A
- WO 200734773 A1
- JP 4089236 A
- JP 2006297730 A
- JP 10006433 A

- JP 11302422 A
- JP 452201 B
- JP 46002050 B
- JP 447134 B
- JP 48078233 A
- JP 50058123 A
- JP 49047916 B
- JP 50006223 B